# EUROPEAN PATENT SPECIFICATION

(11) **EP 0 392 120 B1**
(45) Date of publication and mention of the grant of the patent: **21.09.1994**
(21) Application number: 89312417.2
(22) Date of filing: 29.11.1989
(51) Int. Cl.: H01L 29/60, H01L 29/812, H01L 21/28, H01L 29/10

(54) **Semiconductor device with a gate having asymmetric sidewalls, and a production method thereof**
Halbleiteranordnung unter Verwendung asymmetrischer Seitewände und Verfahren zu ihrer Herstellung
Dispositif semi-conducteur utilisant des parois asymétriques accolées à la porte et méthode pour sa production

(30) Priority: 12.04.1989 JP 93577/89
(43) Date of publication of application: 17.10.1990
(60) Divisional application: 94200376.5
(73) Proprietor: MITSUBISHI DENKI KABUSHIKI KAISHA, Tokyo (JP)
(72) Inventor: Oku, Tomoki Mitsubishi Denki K. K. Optelectronic, Mizuhara 4-chome Itami-shi Hyogo-ken (JP)
(74) Representative: Beresford, Keith Denis Lewis

(56) References cited:
- EP-A- 0 152 615
- EP-A- 0 160 255
- US-A- 4 356 623
- PATENT ABSTRACTS OF JAPAN, vol. 13, no. 243 (E-768)[3591], 7th June 1989; & JP-A-1 44 069
- IDEM
- PATENT ABSTRACTS of JAPAN, vol. 12, no. 348 (E-659)[3195], 19th September 1988; & JP-A-63 107 071

## Description

The present invention relates to a method of manufacturing a semiconductor device, particularly a method of manufacturing a Schottky barrier gate type field effect transistor in which a high concentration active layer which is asymmetrical with respect to the gate is produced by self-aligning process steps.

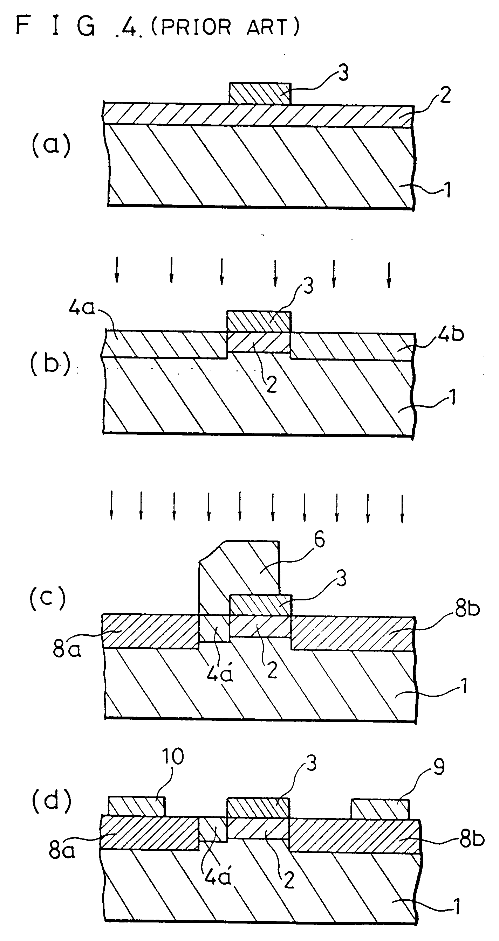

Figures 4(a) to (d) are cross-sectional side views showing major process steps for producing a semiconductor device according to the prior art. In figure 4, reference numeral 1 designates a semi-insulating GaAs substrate. An n type active layer 2 is produced on the semi-insulating GaAs substrate 1. A gate electrode 3 comprising refractory metal is produced on the active layer 2. N′ type intermediate concentration active layers (hereinafter referred to as "n′ layer") 4a (4a′) and 4b are produced at the n type active layer 2. N⁺ type high concentration active layers (hereinafter referred to as "n⁺ layer") 8a and 8b are produced at the n type active layer 2. A source electrode 9 and a drain electrode 10 are produced on the n⁺ layers 8a and 8b, respectively. Reference numeral 6 designates photoresist.

The production method will be described.

First of all, as shown in figure 4(a), an n type active layer 2 is produced on a semi-insulating GaAs substrate 1 by ion implantation or epitaxy growth, and thereafter, a refractory metal is plated on the entire surface of wafer and patterned by a reactive ion etching with using photoresist as a mask, thereby to produce a refractory metal gate electrode 3.

Next, as shown in figure 4(b), ion implantation is conducted with using the refractory metal gate electrode 3 as a mask, whereby n′ layers 4a and 4b are produced at the both sides of the gate electrode 3.

Next, as shown in figure 4(c), photoresist is plated on the entire surface of substrate and patterned in an asymmetrical configuration with respect to the refractory metal gate electrode 3, and ion implantation is conducted with using the patterned photoresist 6 as a mask, whereby n⁺ layers 8a and 8b are produced at asymmetrical positions with respect to the gate electrode 3.

Thereafter, an annealing process is conducted, and further, as shown in figure 4(d), a drain electrode 10 is produced on the n⁺ layer 8a at the side where the n′ layer 4a′ is remaining and a source electrode 9 is produced on the n⁺ layer 8b at the opposite side by vapor deposition and lift-off method, thereby completing a field effect transistor.

In the above-described production method, however, the ion implantation for producing the n⁺ layers 8a and 8b have to be conducted by using the photoresist 6 as a mask, and the distance between the gate electrode 3 and the n⁺ layer 8a below the drain electrode 10 is determined by the precision of patterning. Therefore, in the field effect transistor obtained by the above-described production method, the variation of the gate-drain breakdown voltage is large as well as there may arise variation in the performances of the transistor. Furthermore, since the distance between the gate electrode 3 and the n⁺ layer 8b at the side of source electrode 9 is zero, a sufficient breakdown voltage cannot be obtained.

Another prior art production method will be described.

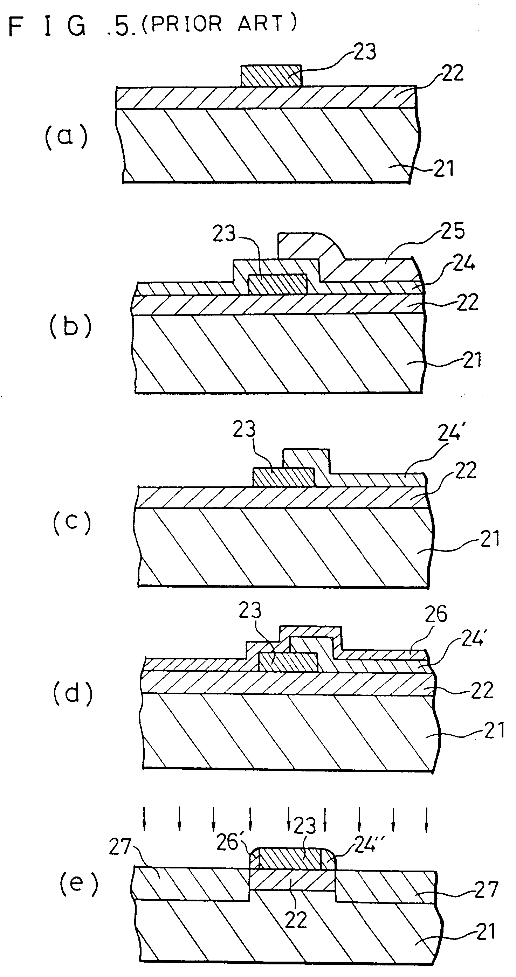

Figures 5(a) to (e) are cross-sectional side views showing major process steps for producing a semiconductor device disclosed in Japanese Laid-open Patent Publication JP-A-63-107071. In figure 5, reference numeral 21 designates a semiconductor substrate. An active region 22 is produced on the semiconductor substrate 21. A gate electrode 23 is produced on the active region 22. A first insulating film 24 (24′, 24˝) is produced on the active region 22. Reference numeral 25 designates photoresist. Reference numeral 26 (26′) designates a second insulating film. Reference numeral 27 designates a contact region.

The production method will be described.

First of all, as shown in figure 5(a), an active region 22 and a gate 23 are produced on the GaAs substrate 21, and thereafter, a first insulating film 24 having a thickness t₁ is plated thereon. Thereafter, photoresist is plated on the entire surface, and an exposure development processing is conducted thereto, thereby to obtain a photoresist 25 having a configuration as shown in figure 5(b). Subsequently, as shown in figure 5(c), a portion of the oxide film 24 is removed by diluted solution of fluoric acid with using the photoresist 25 as a mask. Thereafter, as shown in figure 5(d), after removing the photoresist 25, a second insulating film 26 having thickness t₂ is plated on the entire surface. Then, as shown in figure 5(e), the entire surface is selectively etched thereby to produce asymmetric configuration side walls 24˝ and 26′ at the both sides of the gate 23, and contact regions 27 are produced by ion beam implantation with using the side walls 24˝, 26′ and the gate 23 as a mask. The contact regions 27 are produced to be of asymmetric configurations with respect to the gate 23 by self-alignment due to the difference between the thickness of the side wall 24˝ and that of the side wall 26′.

In such field effect transistor, a predetermined distance is provided between the gate 23 and the both contact layers 27, and therefore, high gate-drain breakdown voltage can be obtained and the leakage between the gate and the source side contact layer 27 can be prevented.

In the prior art production method of a semiconductor device, however, the following problems arise in the actual production steps.

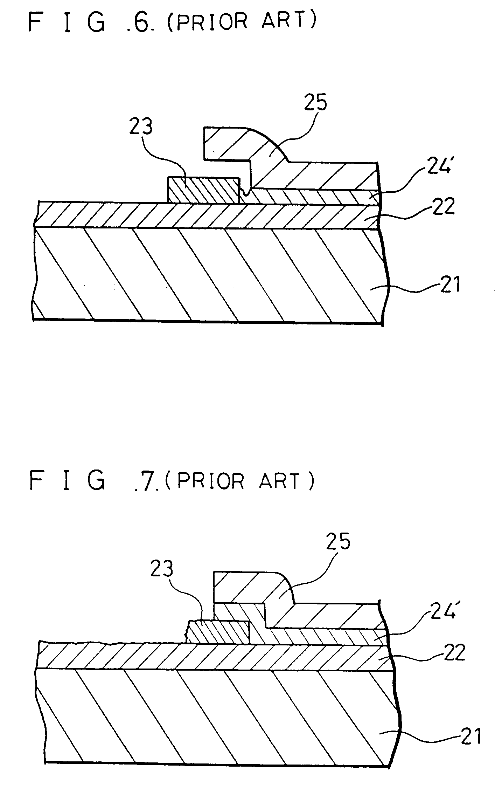

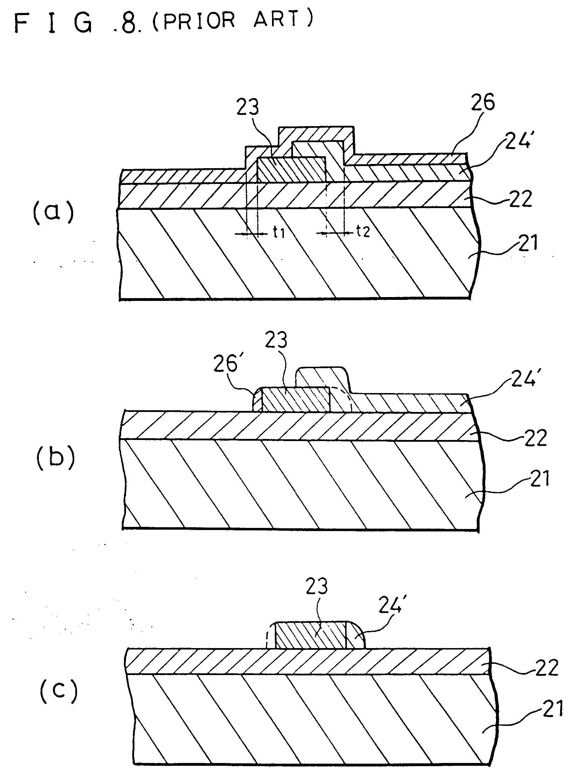

Firstly, in the process of removing the insulating film 24 at the gate side by wet etching with using the photoresist 25 as a mask, as shown in figure 6, since there is no anisotropicity in the etching, the photoresist 25 is peeled off by the side etching, and the etching proceeds up until reaching the first insulating film 24′ below the photoresist 25. Even if this etching is conducted by dry etching, the etching selectivity of the first insulating film 24 against the gate 23 and GaAs substrate 2 is about 1 : 10, and it is difficult to remove only the first insulating film 24 by the etching. Therefore, as shown in figure 7, the surface of substrate and the side wall of gate 23 are also etched at the same time thereby to result in receiving damages, thereby arising variations in the gate length and reductions of active layer 22 in the substrate 21. This results in variations and deteriorations in the FET performance.

Secondly, in the process of producing side wall insulating films 24˝ and 26′ which are asymmetrical at left and right with respect to the gate 23 by RIE, the film thickness of the insulating film is different at left and right of the gate 23 as t₁ : (t₁ + t₂) as shown in figure 8(a), and the time which is required for just etching is differentiated. Therefore, as shown in figure 8(b), when the insulating film 26′ is produced at the side wall of the gate 23, a first insulating film 24′ still remains on the active layer 22 and on a portion of the gate 23. Accordingly, if the insulating film 24′ is further etched up until a side wall insulating film 24˝ comprising the first insulating film 24′ is of a desired configuration, the side wall insulating film 26′ comprising the second insulating film which has already been produced would be almost gone. Thus, a desired side wall insulating film having an asymmetrical configuration will not be obtained, thereby increasing the variation of the gate-drain breakdown voltage. Furthermore, there arise leakages between the gate and source region, thereby deteriorating the FET performances. Furthermore, in this process, the active layer 22 and the gate 23 at the side where the side wall insulating film 26′ is produced will receive damages by etching, thereby deteriorating the FET performances to a great extent.

EP-A-152615 concerns a further method of manufacturing a semiconductor device.

The present invention provides a method which is intended as a solution to the problems aforesaid.

In accordance with the invention there is provided a method of semiconductor device manufacture including the steps of:
forming a stepped structure on the surface of a substrate; and
covering said stepped structure and that surface of the substrate left exposed each side of said stepped structure, with a first layer of insulating material;
which method is characterised by the following steps which are then performed in the order recited:-
etching said first layer to leave remanent side walls of insulating material, one each side of said stepped structure;
masking one of said side walls;
etching to remove the other one of said side walls from one side of said stepped structure;
covering said one of said side walls, said stepped structure and the surface of said substrate which is thus left exposed at said one side of said stepped structure and at one side of said one of said side walls with a second layer of insulating material; and
etching to remove said insulating material to leave side walls one each side of said stepped structure, which side walls are of different respective thickness.

The method above defined is readily applicable to the manufacture of a Schottky barrier gate type field effect transistor, and in particular this can be performed by:-
producing a low concentration active region at a defined position of a semi-insulating compound semiconductor substrate, and producing a gate electrode comprising refractory metal upon said active region;
producing a first insulating film upon said gate electrode and adjacent surface;
etching said first insulating film to produce first side wall films respectively each side of said gate electrode;
using a wet etchant to remove one of said first side wall films at that side of the gate electrode where a source electrode is to be produced;
producing a second insulating film, to a thickness less than that of said first insulating film, upon the remaining first side wall film, gate electrode and adjacent surface;
etching said second insulating film to produce a second side wall film having a narrower width than that of said first side wall film left remaining; and
implanting ions using said first and second side wall films and said gate electrode as a mask to produce high concentration source and drain active regions in asymmetrical configuration at the left and the right sides respectively of said active region below said gate electrode.

The aforementioned side walls can be produced with high precision and this precision is reproducible. This is thus effective to reduce variation in the gate-drain breakdown voltage and transistor performance, from transistor to transistor produced by this method.

In a preferred embodiment of this method, following production of said gate electrode upon said active region, dopant is introduced into said active region so that, following said implanting of ions performed thereafter, intermediate concentration active regions are left remaining between said active region remaining beneath the gate electrode and said high concentration source and drain active regions respectively.

In the accompanying drawings:-
Figures 1(a) to (i) are cross-sectional side views in the major process stps of a production method of a semiconductor device according to a first embodiment of the present invention;
Figures 2(a) and (b) are diagrams for explaining the precision of patterning in the first embodiment;
Figure 3 is a diagram showing a method of controlling the distance between the gate and n⁺ type high concentration active layer and the stability thereof in the first embodiment;
Figures 4(a) to (d) are cross-sectional side views of the major process steps of a production method of a semiconductor device according to a first prior art;
Figures 5(a) to (e) are cross-sectional side views of major process steps of a production method of a semiconductor device according to a second prior art; and
Figure 6, figure 7, and figures 8(a) to (c) are diagrams for explaining the problems in the second prior art.

An embodiment of the present invention will be described in detail with reference to the drawings. The description which follows is given by way of example only.

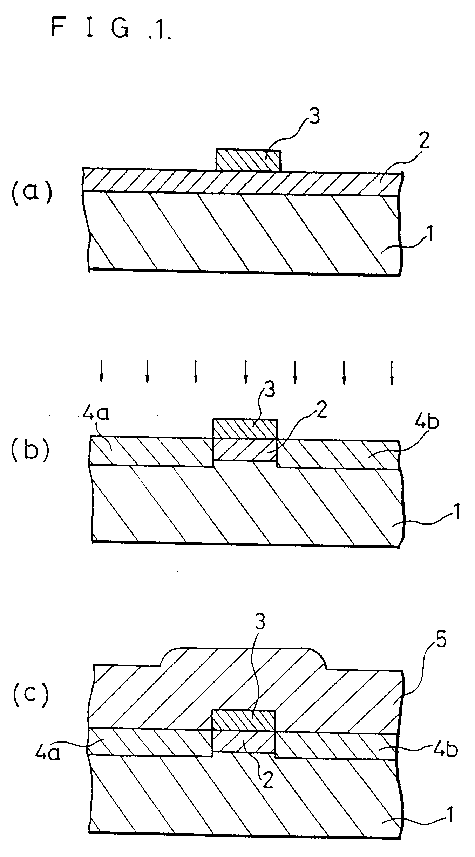

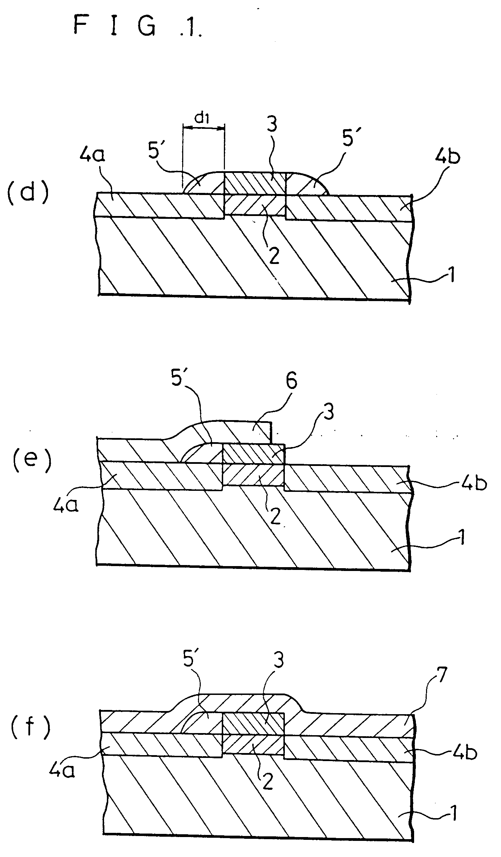

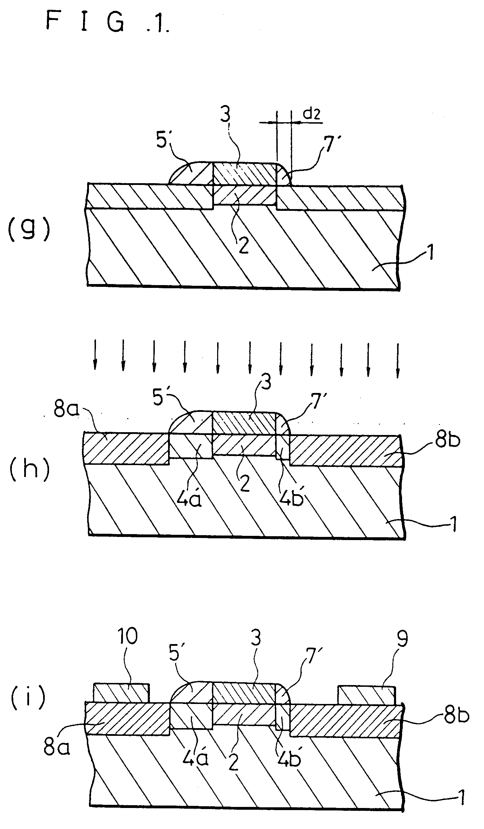

Figures 1(a) to (i) show cross-sectional side views in the major process steps of a production method of a semiconductor device according to a first embodiment of the present invention. In figure 1, the same reference numerals designate the same or corresponding elements as those shown in figure 4. Reference numerals 4a and 4b (4a′ and 4b′) designate n′ type intermediate concentration active layers. Reference numeral 5 (5′) designates first insulating film. Reference numeral 7 (7′) designates second insulating film.

The production process will be described.

First of all, as shown in figure 1(a), an n type active layer 2 of 1000 to 2000 angstroms (10 Å = 1 nm) thickness is produced by conducting ion implantation into a semi-insulating GaAs substrate 1 using ²⁹Si⁺ ions, at conditions of implantation energy of 50 KeV, and impurity concentration of 1 × 10¹² cm⁻² or by conducting epitaxy growth. Thereafter, refractory metal such as WSiₓ is plated on the entire surface of wafer to a thickness of 3000 angstroms by a sputtering deposition method, and it is patterned by reactive ion etching with using photoresist as a mask, thereby producing a refractory metal gate 3 of about 1 micron gate length.

Next, as shown in figure 1(b), ²⁹Si⁺ ions are ion implanted at implantation energy of 50 KeV and impurity concentration of 1 × 10¹² cm⁻² with using the refractory metal gate 3 as a mask, thereby producing n′ type active layers 4a and 4b at the both sides of the gate 3.

Next, as shown in figure 1(c), a first insulating film 5 comprising SiOₓ (x = 1 to 2) is deposited to a thickness of 8000 to 10000 angstroms by conducting such as plasma CVD using mixed gas of SiH₄ + N₂O.

Furthermore, as shown in figure 1(d), the entire surface of wafer is etched by reactive ion etching with using a mixed gas of C₂F₆, CF₄, CHF₃ + O₂, and further, an over-etching is conducted exceeding the etching conclusion point to a degree of about 10 to 30 %, thereby producing side wall assist films 5′ of about 5000 angstroms width comprising the first insulating film 5, at the both side walls of the gate 3.

Next, as shown in figure 1(e), photoresist 6 is patterned so as to mask the side wall assist film 5′ at the side where a drain electrode is to be produced, and the side wall assist film 5′ at the side where a source electrode is to be produced is removed by such as buffered fluoric acid (HF + NH₄F + H₂O) with using the photoresist 6 as a mask.

Thereafter, as shown in figure 1(f), the photoresist 6 is removed by O₂ asher or organic series solution, and the second insulating film 7 comprising SiOₓ (x = 1 to 2) is plated on the entire surface of substrate to a thickness of about 3000 angstroms by such as plasma CVD method with using mixed gas of SiH₄ + N₂O.

Furthermore, as shown in figure 1(g), the entire surface of wafer is over-etched exceeding the etching conclusion point to a degree of 10 to 30 % by reactive ion etching using a mixed gas of C₂F₆, CF₄, CHF₃ + O₂, and the side wall assist film 5′ of about 5000 angstroms width comprising the first insulating film 5 and the side wall assist film 7′ of about 2000 angstroms width comprising a second insulating film 7 are produced at the side walls of the gate 3.

Next, as shown in figure 1(h), ²⁹Si⁺ ions are implanted into the substrate at implantation energy of 60 KeV and impurity concentration of 2 × 10¹³ cm⁻² with using the side wall assist films 5′ and 7′ and the refractory metal gate 3 as a mask, thereby producing n⁺ type high concentration active layers 8a and 8b at asymmetrical positions at left and right with respect to the gate 3.

Thereafter, an annealing process is conducted at 800 °C and for 30 minutes, and as shown in figure 1(i), a source electrode 9 comprising Ni/Ge/Au from below is produced on the n⁺ type high concentration active layer 8b at the side where the side wall assist film 7′ is produced as well as a drain electrode 10 is produced on the n⁺ type high concentration active layer 8a at the opposite side by deposition and lift-off method at the same time, thereby completing a field effect transistor.

The advantages of the present invention over the above-described two prior arts will be described.

First of all, influences affected on the transistor characteristics by the precision of the pattern production will be described.

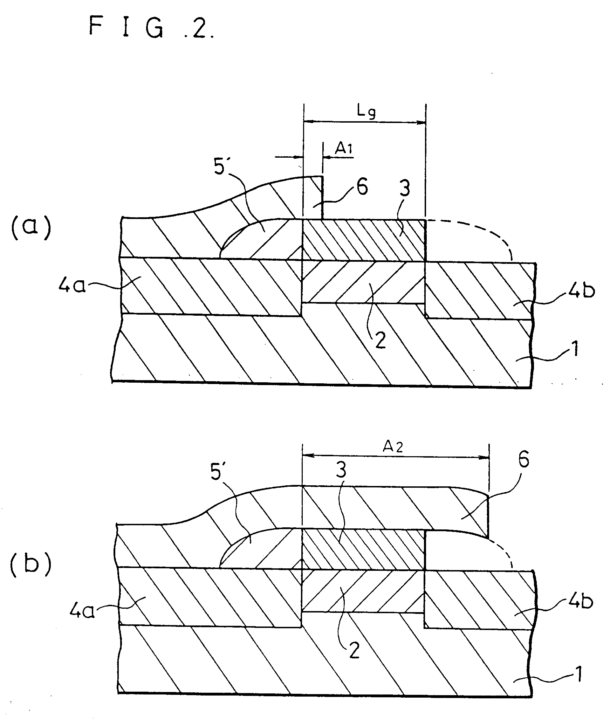

As shown in figure 4(c), in the first prior art, the distance between the gate 3 and the n⁺ type high concentration active layer 8a at the drain side is determined by the variations in the precision of pattern alignment of the photoresist 6. To the contrary, in the present invention, as shown in figures 2(a) and (b), the photoresist 6 only requires to be patterned such that the end surface comes to the position up to A₁∼A₂ from the end of the gate 3 so as to cover the side wall assist films 5′ at the side where a drain electrode is to be produced, and as far as the end surface of the photoresist is held in this range, the result of the etching of the side wall assist films 5′ at the side where a source electrode is to be produced is the same.

Herein, the value of A₁ is required to be such a value that the side wall assist film 5′ at the side where a drain electrode is to be produced is not eroded by permeating the buffered fluoric acid into the interface between the photoresist 6 and the refractory metal gate 3 at the step of soaking the device in buffered fluoric acid. In the experiment, 0.3 micron is obtained therefor. Therefore, this method can be applied to a case where the gate length Lg is above 0.3 microns.

Furthermore, the value of A₂ is only required to be such a value that the photoresist 6 does not cover the side wall assist film 5′ which is to be etched. Furthermore, since the side wall assist film 5′ at the drain side is completely covered by the photoresist 6 and the gate 3 when the side wall assist film 5′ at the source side is removed by etching, there arises no problem such as side etching in the second prior art, and the side wall assist film 5′ can be remained at one side of the gate 3 at high controllability and high reproducibility.

As for the film thickness of the photoresist 6, in the first prior art shown in figure 4(c), in order to make the photoresist 6 function as a mask for ion implantation into the n⁺ type high concentration active layer, the film thickness larger than the range of ion is required. For example, when ²⁹Si⁺ ions are implanted at 60 KeV, a photoresist having a film thickness of about 5000 angstroms is required, and the photoresist 16 having a film thickness of about 1 micron is actually used. To the contrary, in this embodiment, the photoresist is only required to have a thickness capable of being resistant to the etching by fluoric acid. Generally, the etching rate of photoresist to the buffered hydrofluoric acid (mixture of buffer solution and hydrogen fluoride in a ratio of 6 : 1) is several tens A/min, and it can be ignored in practical use. Therefore, in this embodiment, the photoresist film thickness is only required to be about 1000 angstroms while it is required to be about 1 micrometre in the prior art. The fact that such thin photoresist can be used results in a high resolution. Thus, the present invention is advantageous in view of patterning.

Furthermore, in this embodiment, as shown in figures 1(f) to (g), in the process of producing insulating films in asymmetrical configurations at left and right at the side walls of gate 3 by etching, since the film thicknesses of the insulating film 7 are equal to each other at the both sides of the gate 3, the times required for just-etching the insulating films 7 are equal to each other at the left and right sides of the gate, thereby enabling to produce the side wall assist films 5′ and 7′ at high controllability and at high reproducibility.

The above-described photoresist may be any type of photosensitive resin. For example, photosensitive polyimide may be used.

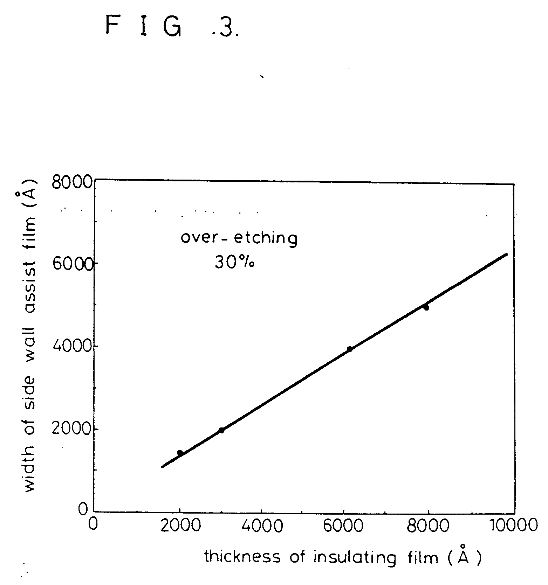

The controllability of the width d₁ and d₂ of the side wall assist films 5′ and 7′ shown in figures 1(d) and (g) will be described. The widths d₁ and d₂ can be controlled by varying the thicknesses of the first insulating film 5 and the second insulating film 7 which are plated in the processes shown in figures 1(c) and (f), respectively. Figure 3 shows the relationship between the thickness of the insulating film and the width of the side wall assist film when the over etching of 30% is conducted. As seen from the figure, the width of the side wall assist film is in direct proportional to the thickness of the insulating film, and this means that the widths d₁ and d₂ can be determined at quite high controllability. Accordingly, d₁ and d₂ may be determined in accordance with required breakdown voltage between gate and drain and that between gate and source. For example, in a case where d₁ is 5000 angstroms as shown in the above-described embodiment, the gate-drain breakdown voltage is 20 V, while in a case where d₂ is 2000 angstroms, the gate-source breakdown voltage is about 7 V. This high controllability of d₁ and d₂ brings about the stability of mutual conductance gₘ which is a characteristics of a transistor, thereby enabling to produce a high performance element at high precision.

While in the above-illustrated embodiment a semi-insulating GaAs substrate is used, the present invention may be applied to a field effect transistor using other compound semiconductor with the same effects as described above.

While in the above-illustrated embodiment the first insulating film 5 and the second insulating film 7 comprise SiOₓ, the insulating films may not be restricted thereto and they are only required to be produced in configurations shown in figure 1(c) or (f) by plasma CVD. For example, SiN or AlN may be used.

While in the above-illustrated embodiment the side wall assist films 5′ and 7′ are remained after the ion implantation, these side wall assist films may be removed by such as fluoric acid after the ion implantation process.

While in the above-illustrated embodiment the intermediate concentration active layers 4a′ and 4b′ are produced at below the side wall assist films 5′ and 7′ thereby to produce an LDD structure field effect transistor, the present invention may not be restricted to this structure. That is, the process of figure 1(b) may be removed, and high concentration active regions 8a and 8b may be produced without providing intermediate concentration active layers.

As is evident from the foregoing description, side wall assist films are produced at both side walls of refractory metal gate in asymmetrical configurations at left and right, and high concentration active layers are self-alignedly produced at asymmetrical positions at left and right by conducting ion implantation with using the side walls as a mask. Therefore, variations in the gate-drain breakdown voltage and the source-gate breakdown voltage and variations in the transistor performances can be reduced, thereby enabling to produce a field effect transistor having a stable transistor breakdown voltage and stable performances at high precision and at high reproducibility.

## Claims

1. A method of semiconductor device manufacture including the steps of:
forming a stepped structure (3) on the surface (2) of a substrate (1); and
covering said stepped structure (3) and that surface (2) of the substrate (1) left exposed each side of said stepped structure (3), with a first layer (5) of insulating material;
which method is characterised by the following steps which are then performed in the order recited:-
etching said first layer (5) to leave remanent side walls (5′) of insulating material, one each side of said stepped structure (3);
masking (6) one of said side walls (5′);
etching to remove the other one of said side walls (5′) from one side of said stepped structure (3);
covering said one of said side walls (5′), said stepped structure (3) and the surface of said substrate (2,1) which is thus left exposed at said one side of said stepped structure (3) and at one side of said one of said side walls (5′) with a second layer (7) of insulating material; and
etching to remove said insulating material (7) to leave side walls (5′,7′), one each side of said stepped structure (3), which side walls are of different respective thickness.

2. A method, as claimed in claim 1, for producing a Schottky barrier gate type field effect transistor, when performed as follows:
producing a low concentration active region (2) at a defined position in a semi-insulating compound semiconductor substrate (1), and producing a gate electrode (3) comprising refractory metal upon said active region (2);
producing a first insulating film (5) upon said gate electrode (3) and adjacent surface (4a, 4b);
etching said first insulating film (5) to produce first side wall films (5′) respectively each side of said gate electrode (3);
using a wet etchant to remove one of said first side wall films (5′) at that side of the gate electrode (3) where a source electrode (9) is to be produced;
producing a second insulating film (7), to a thickness less than that of said first insulating film (5), upon the remaining first side wall film (5′), gate electrode (3) and adjacent surface (4a, 4b);
etching said second insulating film (7) to produce a second side wall film (7′) having a narrower width than that of said first side wall film (5′) left remaining; and
implanting ions using said first and second side wall films (5′,7′) and said gate electrode (3) as a mask to produce high concentration source and drain active regions (8a,8b) in asymmetrical configuration at the left and the right sides respectively of said active region (Z) below said gate electrode (3).

3. A method as claimed in claim 2 wherein following the production of said gate electrode (3) upon said active region (2), dopant is introduced into said active region (2) so that, following said implanting of ions performed thereafter, intermediate concentration active regions (4a′, 4b′) are left remaining between said active region (2) remaining beneath the gate electrode (3) and said high concentration source and drain active regions (8a,8b) respectively.

4. A method as claimed in either one of the preceding claims 2 or 3, wherein said etching of said first and second insulating films (5,7) is in each case conducted by reactive ion etching.

5. A method as claimed in claim 4, wherein said etching of said first and second insulating films (5,7) is in each case followed by an over etching exceeding the etching conclusion point by 10 to 30%.

6. A method as claimed in claim 5 wherein said over etching is conducted by reactive ion etching using a mixed gas of C₂F₆, CF₄, CHF₃ + O₂.

7. A method as claimed in any one of the preceding claims wherein:
after said etching of the first layer (5) to leave remanent side walls (5′), a resist is coated onto the stepped structure (3), side walls (5′) and adjacent surface (4a, 4b), then patterned and developed to expose one only of the two side walls (5′); and thereafter the substrate immersed in buffered fluoric acid to remove the one side walls (5′) exposed.

8. A method as claimed in any one of the preceding claims wherein each of said side walls (5′,7′) respectively comprises silicon oxide (SiOx), silicon nitride (SiN) or aluminium nitride (AlN).

9. A method as claimed in claim 2 or in any one of the preceding claims depending from claim 2, wherein said first and second side wall films are removed following said implanting of ions to produce said high concentration source and drain active regions (8a,8b).

## Patentansprüche

1. Verfahren zur Herstellung einer Halbleitervorrichtung, welches die Schritte aufweist:
Bilden einer gestuften Struktur (3) auf der Oberfläche (2) eines Substrates (1); und
Bedecken der gestuften Struktur (3) und der auf jeder Seite der gestuften Struktur (3) freigelassenen Oberfläche (2) des Substrates (1) mit einer ersten Schicht (5) von Isoliermaterial;
wobei das Verfahren durch die folgenden Schritte gekennzeichnet ist, die dann in der genannten Reihenfolge ausgeführt werden:
Ätzen der ersten Schicht (5), um auf jeder Seite der gestuften Struktur (3) jeweils eine verbleibende Seitenwand (5′) aus Isoliermaterial zu hinterlassen;
Maskieren (6) einer der Seitenwände (5′);
Ätzen, um die andere der Seitenwände (5′) von einer Seite der gestuften Struktur (3) zu entfernen;
Bedecken der einen der Seitenwände (5′), der gestuften Struktur (3) und der Oberfläche des Substrates (2, 1), das somit auf dieser einen Seite der gestuften Struktur (3) freigelassen ist, und auf einer Seite der einen der Seitenwände (5′) mit einer zweiten Schicht (7) aus Isoliermaterial; und
Ätzen zur Entfernung des Isoliermaterials (7), um Seitenwände (5′, 7′), jeweils eine auf jeder Seite der gestuften Struktur (3), zu belassen, welche Seitenwände jeweils eine unterschiedliche Dicke aufweisen.

2. Verfahren nach Anspruch 1 zur Herstellung eines Feldeffekttransistors vom Schottky-Übergangs-Gate-Typ, wenn es folgendermaßen durchgeführt wird:
Herstellen eines aktiven Bereiches (2) mit geringer Konzentration an einer vorgegebenen Position in einem semiisolierenden Verbund-Halbleitersubstrat (1) und Herstellen einer Gate-Elektrode (3) mit wärmefestem Metall auf dem aktiven Bereich (2);
Herstellen eines ersten Isolierfilmes (5) auf der Gate-Elektrode (3) und der angrenzenden Oberfläche (4a, 4b);
Ätzen des ersten Isolierfilmes (5), um auf jeder Seite der Gate-Elektrode jeweils einen ersten Seitenwandfilm (5′) herzustellen;
Verwenden eines Naßätzmittels, um eine der ersten Seitenwandfilme (5′) auf derjenigen Seite der Gate-Elektrode (3) zu entfernen, auf der eine Source-Elektrode (9) hergestellt werden soll;
Herstellen eines zweiten Isolierfilmes (7) bis zu einer Dicke, die geringer ist als diejenige des ersten Isolierfilmes (5) auf dem verbleibenden ersten Seitenwandfilm (5′), der Gate-Elektrode (3) und der angrenzenden Oberfläche (4a, 4b);
Ätzen des zweiten Isolierfilmes (7), um einen zweiten Seitenwandfilm (7′) mit einer geringeren Breite als der übriggelassene erste Seitenwandfilm (5′) herzustellen; und
Implantieren von Ionen unter Verwendung des ersten und zweiten Seitenwandfilmes (5′, 7′) und der Gate-Elektrode (3) als Maske, um auf der linken und rechten Seite des aktiven Bereiches (Z) unterhalb der Gate-Elektrode (3) aktive Source- bzw. Drain-Bereiche (8a, 8b) mit hoher Konzentration in asymmetrischer Konfiguration herzustellen.

3. Verfahren nach Anspruch 2, wobei nach der Herstellung der Gate-Elektrode (3) auf dem aktiven Bereich (2) ein Dotierungsmittel in den aktiven Bereich (2) eingebracht wird, so daß nach der darauffolgend durchgeführten Ionenimplantation die dazwischenliegenden aktiven Konzentrationsbereiche (4a′, 4b′) zwischen dem unterhalb der Gate-Elektrode (3) verbleibenden aktiven Bereich (2) und dem aktiven Source- bzw. Drainbereich (8a, 8b) mit hoher Kozentration zurückbelassen werden.

4. Verfahren nach einem der vorhergegangenen Ansprüche 2 oder 3, bei dem das Ätzen des ersten und zweiten Isolierfilmes (5, 7) in jedem Fall durch reaktives Ionenätzen durchgeführt wird.

5. Verfahren nach Anspruch 4, bei dem das Ätzen des ersten und zweiten Isolierfilmes (5, 7) in jedem Fall von einem Überätzen gefolgt ist, welches den Ätzungsendpunkt um 10 bis 30% überschreitet.

6. Verfahren nach Anspruch 5, bei dem das Überätzen durch reaktives Ionenätzen unter Verwendung eines gemischten Gases aus C₂F₆, CF₄, CHF₃ + O₂ durchgeführt wird.

7. Verfahren nach einem der vorangegangenen Ansprüche, bei dem:
nach dem Ätzen der ersten Schicht (5), um verbleibende Seitenwände (5′) zu belassen ein Abdeckmittel auf die gestufte Struktur (3), die Seitenwände (5′) und die angrenzenden Oberfläche (4, 4b) abgeschieden, anschließend strukturiert und entwickelt wird, um nur eine der beiden Seitenwände (5′) freizulegen; und daran anschließend das Substrat in gepufferte Fluorsäure getaucht wird, um die freiliegende Seitenwand (5′) zu entfernen.

8. Verfahren nach einem der vorangegangenen Ansprüche, bei dem jede der Seitenwände (5′, 7′) jeweils Siliziumoxid (SiOₓ), Siliziumnitrid (SiN) bzw. Aluminiumnitrid (AlN) aufweist.

9. Verfahren nach Anspruch 2 oder einem der auf Anspruch 2 zurückbezogenen Ansprüche, bei dem der erste und der zweite Seitenwandfilm nach der Ionenimplantation entfernt werden, um den aktiven Source- und Drainbereich (8a, 8b) mit hoher Konzentration herzustellen.

## Revendications

1. Procédé de fabrication d'un dispositif semiconducteur comprenant les étapes de :
former une structure à palier (3) sur la surface (2) d'un substrat (1); et
recouvrir la structure à palier (3) et la surface (2) du substrat (1) laissée exposée à chaque côté de la structure à palier (3), d'une première couche (5) en matériau isolant;
lequel procédé est caractérisé par les étapes suivantes qui sont ensuite accomplies dans l'ordre écrit :-
attaquer ladite première couche (5) pour laisser des parois latérales rémanentes (5′) de matériau isolant, une de chaque côté de la structure à palier (3);
masquer (6) l'une desdites parois latérales (5′);
attaquer pour retirer l'autre desdites parois latérales (5′) d'un côté de la structure à palier (3);
recouvrir ladite une desdites parois latérales (5′), ladite structure à palier (3) et la surface dudit substrat (2,1) qui est ainsi laissée exposée audit côté de la structure à palier (3) et à un côté de ladite une desdites parois latérales (5′) d'une seconde couche (7) en matériau isolant; et
attaquer pour retirer ledit matériau isolant (7) pour laisser des parois latérales (5′,7′), l'une à chaque côté de la structure à palier (3), lesquelles parois latérales sont d'épaisseurs respectives différentes.

2. Procédé, tel que revendiqué en revendication 1, pour produire un transistor à effet de champ du type à porte de barrière de Schottky, lorsqu'accompli comme suit :
produire une région active de faible concentration (2) à une position définie dans. un substrat semi-conducteur composé semi-isolant (1), et produire une électrode de porte (3) comprenant un matériau réfractaire sur ladite région active (2);
produire un premier film isolant (5) sur ladite électrode de porte (3) et une surface adjacente (4a,4b);
attaquer ledit premier film isolant (5) pour produire des premiers films de paroi latérale (5′) respectivement de chaque côté de ladite électrode de porte (3);
utiliser un réactif d'attaque liquide pour retirer l'un desdits premiers films de paroi latérale (5′) au côté de l'électrode de porte (3) où une électrode de source (9) doit être produite;
produire un second film isolant (7), à une épaisseur inférieure à celle du premier film isolant (5), sur le premier film restant de paroi latérale (5′), l'électrode de porte (3) et la surface adjacente (4a, 4b);
attaquer ledit second film isolant (7) pour produire un second film de paroi latérale (7′) ayant une largeur plus étroite que celle dudit premier film de paroi latérale (5′) laissé restant; et
implanter des ions en utilisant lesdits premier et second films de paroi latérale (5′ ,7′ ) et ladite électrode de porte (3) comme masque pour produire des régions actives de source et de drain de concentration élevée (8a,8b) en configuration asymétrique aux côtés à gauche et à droite, respectivement, de ladite région active (Z) en dessous de ladite électrode de porte (3).

3. Procédé comme revendiqué en revendication 2, dans lequel suivant la production de l'électrode de porte précitée (3) sur la région active précitée (2), du dopant est introduit dans ladite région active (2) de sorte que, suivant l'implantation précitée d'ions accomplie après cela, des régions actives de concentration intermédiaire (4a′, 4b′) soient laissées restantes entre ladite région active (2) restant en dessous de l'électrode de porte (3) et lesdites régions actives de source et de drain de concentration élevée (8a, 8b), respectivement.

4. Procédé comme revendiqué dans l'une ou l'autre des revendications précédentes 2 ou 3, dans lequel l'attaque précitée des premier et second films isolants (5,7) est dans chaque cas conduite par attaque d'ions réactifs.

5. Procédé comme revendiqué en revendication 4, dans lequel l'attaque précitée des premier et second films isolants précités (5,7) est dans chaque cas suivie par une sur-attaque dépassant le point de conclusion d'attaque de 10 à 30%.

6. Procédé comme revendiqué en revendication 5, dans lequel la sur-attaque précitée est conduite par attaque à ions réactifs utilisant un gaz mélangé de C₂F₆, CF₄, CHF₃+O₂.

7. Procédé comme revendiqué dans l'une quelconque des revendications précédentes, dans lequel :
après l'attaque précitée de la première couche (5) pour laisser des parois latérales rémanentes (5′), un résist est revêtu sur la structure à palier (3), les parois latérales (5′) et la surface adjacente (4a, 4b), ensuite formé de motifs et développé pour exposer seulement l'une des deux parois latérales (5′); et ensuite le substrat est immergé dans de l'acide fluorique tamponné pour retirer la paroi latérale (5′) exposée.

8. Procédé comme revendiqué dans l'une quelconque des revendications précédentes, dans lequel chacune des parois latérales précitées (5′,7′) comprend respectivement de l'oxyde de silicium (SiOx), du nitrure de silicium (SiN) ou du nitrure d'aluminium (AlN).

9. Procédé comme revendiqué en revendication 2 ou dans l'une quelconque des revendications précédentes dépendant de la revendication 2, dans lequel les premier et second films de paroi latérale sont retirés suivant l'implantation précitée d'ions pour produire les régions précitées actives de source et de drain de concentration élevée (8a,8b).
